# EUROPÄISCHE PATENTSCHRIFT

(11) **EP 0 905 491 B1**
(45) Veröffentlichungstag und Bekanntmachung des Hinweises auf die Patenterteilung: **12.05.2004**
(21) Anmeldenummer: 98111699.9
(22) Anmeldetag: 25.06.1998
(51) Int. Cl.: G01J 3/44, G21K 1/06

(54) **Vorrichtung zur wellenlängen-dispersiven Analyse von Fluoreszenzstrahlung**
Device for the analysis of wavelength dispersion of fluorescent rays
Dispositif d'analyse de la dispersion des longeurs d'onde des rayons fluorescents

(30) Priorität: 03.09.1997 DE 19738408
(43) Veröffentlichungstag der Anmeldung: 31.03.1999
(73) Patentinhaber: GKSS-Forschungszentrum Geesthacht GmbH, 21502 Geesthacht (DE)
(72) Erfinder: Schwenke, Heinrich, 21039 Escheburg (DE); Knoth, Joachim, 21029 Hamburg (DE); Schneider, Harald, 21502 Geesthacht (DE); Beaven, Peter, Dr., 21465 Reinbek (DE)
(74) Vertreter: Niedmers, Ole, Dipl.-Phys.

(56) Entgegenhaltungen:
- WO-A-95/23963
- WO-A-96/23211
- DE-A- 4 417 307
- US-A- 4 698 833

## Beschreibung

Die Erfindung betrifft eine Vorrichtung zur wellenlängendispersiven Analyse von Fluoreszenzstrahlung, die von einer Probenoberfläche, insbesondere von einer zu untersuchenden Waferoberfläche, emittiert wird, nachdem auf die Probenoberfläche primäre Strahlung gerichtet worden war, wobei die Fluoreszenzstrahlung auf einen relativ zur Richtung der einfallenden Fluoreszenzstrahlung drehbaren Multilayer-Röntgenspiegel geleitet wird, dessen emittierte Strahlen auf einen Detektor gegeben werden.

Vorrichtungen der eingangs genannten Art zur wellenlängen-dispersiven Analyse von Fluoreszenzstrahlung, die auf einer Probe infolge der Beaufschlagung der Probe mit Röntgenstrahlung, Elektronenstrahlung oder aber auch anderer geeigneter Strahlung erzeugt wird, werden für viele Zwecke der Spurenanalyse verwendet. Ein besonderes Anwendungsgebiet derartiger Vorrichtungen, auf die allerdings die Anwendung keineswegs beschränkt ist, ist beispielsweise der spurenanalytische Nachweis von Kontaminationen von Waferoberflächen, wobei die Wafer bekannterweise zur Herstellung von Halbleitern für vielfältigsten Anwendungszwecke dienen. Derartige Vorrichtungen werden insbesondere zum Nachweis von Kontaminationen durch leichte Elemente auf Waferoberflächen verwendet.

Grundsätzlich gilt, daß bei wellenlängen-dispersiver Analyse von Fluoreszenzstrahlung als Folge primärer Röntgenstrahlung, die auf einer Probe einfallen, zwei miteinander in Konflikt stehende Forderungen zu erfüllen sind. Ein Analysator dafür sollte möglichst effizient sein, d.h. er sollte einen möglichst großen Teil der von einem Objekt ausgehenden Strahlung erfassen und er sollte außerdem eine möglichst hohe Auflösung erreichen. Derzeit sind nur zwei Klassen wellenlängen-dispergierender Elemente gebräuchlich, nämlich natürliche Kristalle, an deren Struktur Bragg-Reflexion eintritt, oder sogenannte Multilayer-Röntgenspiegel, die Bragg-Interferenzen durch die Totalreflexion von Röntgenstrahlen an künstlich hergestellten dünnen Schichten erzeugen. Analysatoren auf der Basis natürlicher Kristalle zeichnen sich in der Regel durch eine gute Energieauflösung bei geringer Intensität aus, wohingegen Multilayerspiegel eine wesentlich höhere Effizienz aufweisen, die jedoch auf Kosten der Auflösung geht.

Die eingangs geschilderte Gattung der Vorrichtung umfaßt die im Stand der Technik gebräuchliche Gattung der Vorrichtung mit einem Multilayer-Röntgenspiegel. Bei dieser bekannten Vorrichtung wird beispielsweise eine Probenfläche von wenigen cm² mit geeigneter primärer Röntgenstrahlung bestrahlt. Die resultierende Fluoreszenzstrahlung wird unter einem Winkel von etwa 45°, bezogen auf die Probenoberfläche, ggf. unter Zwischenschaltung eines geeigneten Kollimators, auf den Multilayerspiegel gelenkt. Der Auftreffwinkel der Fluoreszenzstrahlung auf dem Multilayerspiegel bestimmt die Wellenlänge der reflektierten Strahlung, welche einen Detektor beispielsweise in Form eines Zählrohres trifft. Dieser Winkel wird durch Drehung des Multilayerspiegels in kleinen Winkelschritten verändert, so daß mittels des Detektors ein Spektrum der Fluoreszenzintensität als Funktion des Reflexionswinkels bzw. der Wellenlänge schrittweise aufgenommen werden kann.

DE 4 417 307 A1 offenbart eine Anordnung zur wellenlängen-dispersiven Analyse von Fluoreszenzstrahlung mit einem Paar von multilayerspiegeln.

Wie oben erwähnt, ist die Verwendung eines Multilayerspiegels als Röntgenspiegel dahingehend problematisch, daß sie zwar eine wesentlich höhere Effizienz aufweisen, die damit erreichbare Auflösung jedoch nachteiligerweise begrenzt ist bzw. nicht die Höhe erreicht, die für die gattungsgemäßen Analysen wünschenswert, in vielen Fällen sogar unabdingbar erforderlich sind.

Es ist deshalb Aufgabe der vorliegenden Erfindung, eine Vorrichtung der eingangs genannten Art zu schaffen, mit der sowohl die Intensitätsausbeute als auch das Auflösungsvermögen entscheidend verbessert bzw. erhöht wird, wobei die Vorrichtung mit verhältnismäßig einfachen Mitteln realisiert werden können soll, um diese auch kostengünstig realisieren zu können und somit auch kostengünstig einsetzen zu können, insbesondere auch unmittelbar am Ort der durchzuführenden Analyse von Proben.

Gelöst wird die Aufgabe gemäß der Erfindung dadurch, daß der Reflexionswinkel α, unter dem die Fluoreszenzstrahlung von der Probenoberfläche emittiert wird, << 45° ist, daß der Multilayer-Röntgenspiegel durch ein Paar voneinander beabstandeter Multilayerspiegel gebildet wird und daß die Dicke der Vielfachschichten der Multilayerspiegel mit der Länge der Multilayerspiegel vom Ort der Probe in Richtung des Detektors größer wird.

Der Vorteil der erfindungsgemäßen Lösung besteht im wesentlichen darin, daß die erfindungsgemäße Lösung eine für die wellenlängen-dispersive Analysetechnik an sich ungewöhnliche Kombination von aufeinander abgestimmten Maßnahmen ist, nämlich eine vom Üblichen abweichende Geometrie, sowie zwei Multilayerspiegel mit zunehmender Dicke der Vielfachschichten der Multilayerspiegel mit deren Länge vom Ort der Probe in Richtung des Detektors. Dadurch wird es erfindungsgemäß vorteilhafterweise möglich, gleichzeitig zwei einander normalerweise widersprechende Ziele zu erreichen, nämlich eine wesentliche Erhöhung der Auflösung und eine signifikante Verkürzung der Meßzeit pro Probe.

Bei einer vorteilhaften Ausgestaltung der Vorrichtung liegt der Reflexionswinkel α im Bereich von 3° bis 0,05°, je nach der Art der zu untersuchenden Probe, wobei mit diesem Winkelintervall bei den zu untersuchenden Proben sehr gute Analyseergebnisse erreicht worden sind.

Ganz besonders gute Analyseergebnisse sind mit einem Reflexionswinkel α erreicht worden, der im wesentlichen 1° groß ist. Bei diesem Reflexionswinkel und der erfindungsgemäßen Anordnung konnte eine Auflösung, die mit einer gattungsgemäßen Vorrichtung bei 31 eV lag, auf 27 eV gesteigert werden.

Obwohl nicht zwingend erforderlich, kann es für bestimmte Ausgestaltungen der Vorrichtung aber vorteilhaft sein, die Multilayerspiegel parallel voneinander zu beabstanden, obwohl dieses ggf. für bestimmte Reflexionsparameter, die eingestellt werden sollen, nicht erforderlich ist.

Bei einer noch anderen vorteilhaften Ausführungsform der Vorrichtung ist die Länge des ersten, näher zur Probe gerichteten Multilayerspiegels kleiner als die Länge des zweiten, näher zum Detektor gerichteten Multilayerspiegels. Durch diese Maßnahme wird vorteilhafterweise erreicht, daß der gesamte Anteil der Fluoreszenzstrahlung, der nach der Reflektion von der Probe auf den ersten Multilayerspiegel reflektiert wird, nachdem er von dort wiederum reflektiert wird, vollständig vom zweiten Multilayerspiegel zur erneuten Reflektion daran erfaßt werden kann.

Vorteilhaft ist es auch, daß der Gradient des sog. "d-spacing" des ersten, näher zur Probe gerichteten Multilayerspiegels größer als der Gradient des "d-spacing" des zweiten, näher zum Detektor gerichteten Multilayerspiegels ist. Für die Gradienten der entsprechenden d-spacing gilt, daß sie umgekehrt proportional zur Spiegellänge sind.

Schließlich wird die Länge der Multilayerspiegel vorzugsweise so gewählt, daß sie proportional zur Länge ist, die die Fluoreszenzstrahlung von der Probenoberfläche zur jeweiligen Mitte der Multilayerspiegel zurücklegt.

Die Erfindung wird nun unter Bezugnahme auf die nachfolgenden schematischen Zeichnungen anhand eines Ausführungsbeispiels sowie anhand von in diesem Zusammenhang angestellten Modellrechnungen beschrieben. Darin zeigen:
- Fig. 1: schematisch eine Vorrichtung zur wellenlängendispersiven Analyse von Fluoreszenzstrahlung, wie sie bisher im Stand der Technik bekannt ist und so auch in vielen Fällen verwendet wird,
- Fig. 2: den schematischen Aufbau der erfindungsgemäßen Vorrichtung,

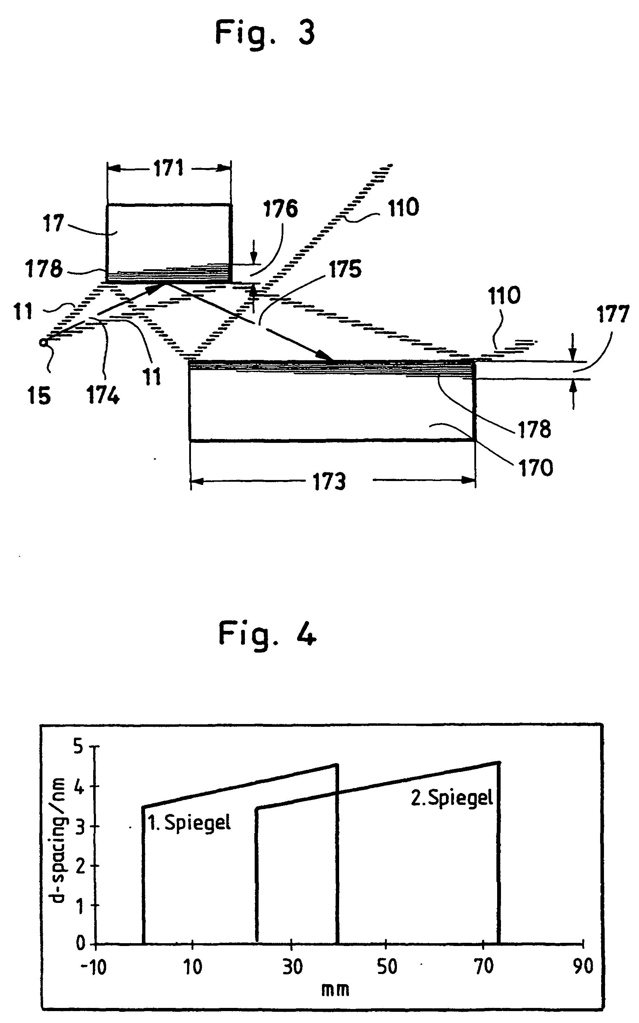

- Fig. 3: eine schematische Darstellung der beiden Multilayerspiegel und eine Darstellung des Strahlenganges der daran reflektierten Fluoreszenzstrahlung,
- Fig. 4: in Form einer graphischen Darstellung unter Bezugnahme auf die Abbildung von Fig. 3 typische, realistische Werte für das "d-spacing", die Länge und die innere Position (Versetzung) zweier Spiegel gemäß der erfindungsgemäßen Vorrichtung,
- Fig. 5: in Form einer graphischen Darstellung das Ergebnis einer Modellrechnung nach dem sogenannten "ray-tracing"-Verfahren unter der Annahme, daß eine zu analysierende Probe unter dem Einfluß der Primärstrahlung zwei monoenergetische Fluoreszenzlinien gleicher Intensität aussendet, für die Vorrichtung gemäß Stand der Technik
- Fig. 6: in Form einer graphischen Darstellung das Ergebnis einer Modellrechnung für die erfindungsgemäße Lösung, gerechnet für dieselben Fluoreszenzlinien bei gleicher Primärintensität, Probengröße und Zusammensetzung wie beim Beispiel von Fig. 5.

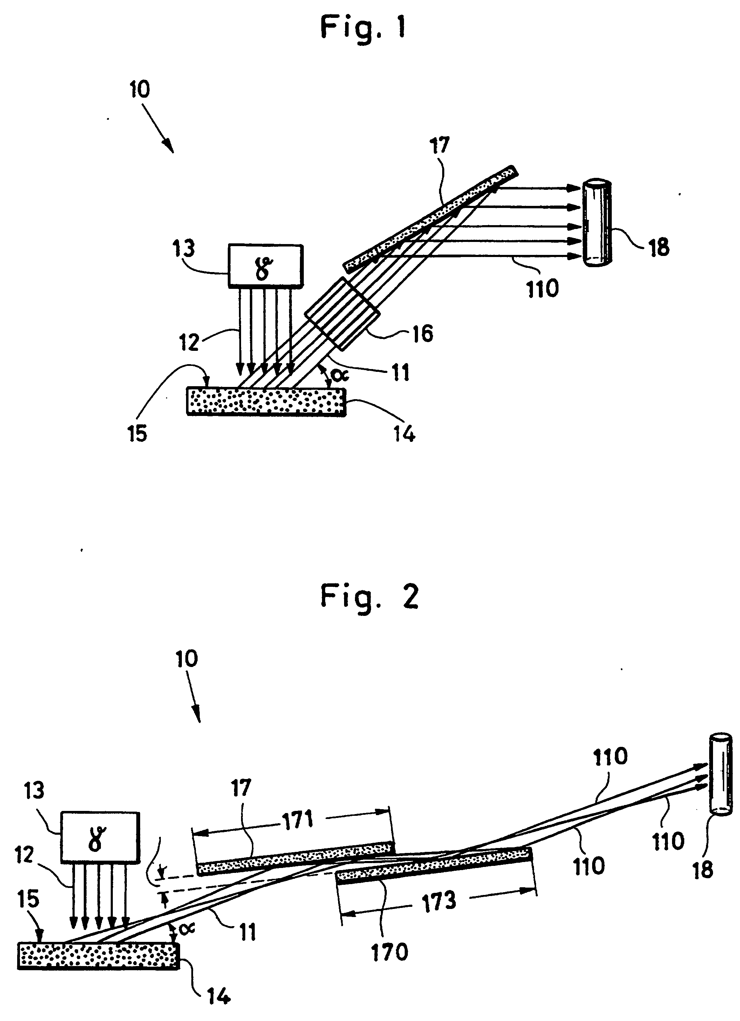

Die im Stand der Technik bekannte Vorrichtung 10 wird anhand des in Fig. 1 dargestellten schematischen Aufbaus erläutert. Die erfindungsgemäße Lösung gemäß Fig. 2 wird dann nachfolgend anhand der Darstellungen der Figuren 1 und 2 erläutert.

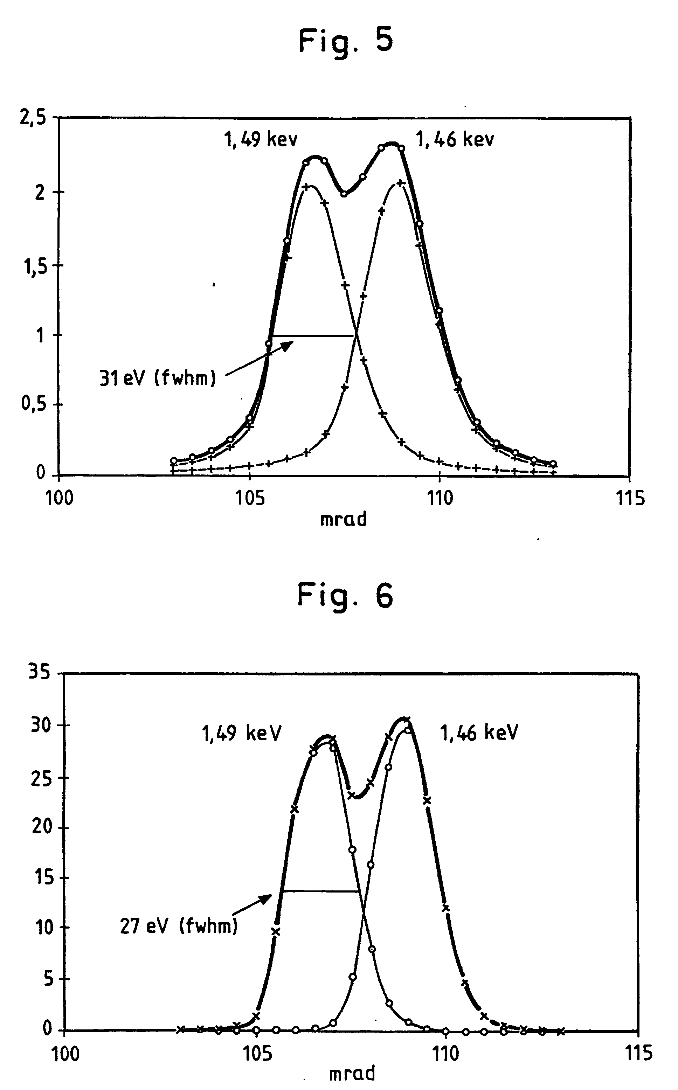

Die Vorrichtung 10 zur wellenlängen-dispersiven Analyse von Fluoreszenzstrahlung 11, die von einer Probenoberfläche 15 herrührt, weist folgenden Aufbau auf. Von einer Röntgenstrahlungsquelle 13, die beispielsweise eine Röntgenröhre, aber auch eine sonstige beliebige geeignete Strahlungsquelle sein kann, wird Strahlung (Primärstrahlung) auf eine Probe 14 gegeben. Diese Probe 14 besteht beispielsweise aus einem Wafer, wie er zur Herstellung von elektronischen Halbleiterbauelementen verwendet wird. Mittels der Vorrichtung 10 soll auf der Oberfläche der Probe 14, beispielsweise in Form des Wafers, eine mögliche Kontamination der Probenoberfläche 15 mit leichten Elementen erfaßt bzw. analysiert werden. Die auf die Probe 14 einfallende Röntgenstrahlung 12 wird nach der Reflexion auf der Probenoberfläche 15 als Fluoreszenzstrahlung 11 unter einem Winkel von etwa 45°, bezogen auf die Probenoberfläche 15, über einen Kollimator 16, beispielsweise in Form eines sogenannten Soller-Kollimators, auf einen Multilayer-Röntgenspiegel 17 gelenkt. Der Auftreffwinkel der Fluoreszenzstrahlung 11 auf dem Multilayerspiegel 17 bestimmt die Wellenlänge der reflektierten Fluoreszenzstrahlung 110, die nachfolgend einen ortsunabhängigen Detektor 18 erreicht, der beispielsweise in Form eines Zählrohres ausgebildet ist. Dieser Winkel wird durch Drehung des Multilayerspiegels 17 in kleinen Winkelschritten verändert, so daß mittels des Detektors 18 ein Spektrum der Fluoreszenzintensität als Funktion des Reflexionswinkels bzw. der Wellenlänge schrittweise aufgenommen werden kann, vgl. auch Fig. 5.

Die erfindungsgemäße Lösung gemäß Fig. 2 geht von einem Grundaufbau der Vorrichtung 10 aus, wie er vorangehend im Zusammenhang mit Fig. 1 beschrieben worden ist.

Ein gravierender Unterschied bei der erfindungsgemäßen Vorrichtung 10 gegenüber der aus Fig. 1 bekannten ist der, daß der Reflexionswinkel α, unter dem die Fluoreszenzstrahlung 11 von der Probenoberfläche 15 emittiert wird, << 45° ist, d.h. beispielsweise im Bereich von 1° gewählt ist. Ein weiterer wesentlicher Unterschied der erfindungsgemäßen Vorrichtung 10 gegenüber der in Fig. 1 dargestellten ist der, daß der Multilayer-Röntgenspiegel durch ein Paar voneinander beabstandeter Multilayerspiegel 17, 170 gebildet wird und daß schließlich als weiterer wesentlicher Unterschied gegenüber dem Stand der Technik die erfindungsgemäße Vorrichtung 10 die jeweilige Dicke 176, 177 der Vielfachschichten 18 der Multilayerspiegel 17, 170 nicht konstant über die Länge 171, 173 der Multilayerspiegel 17, 170 ist, sondern vom Ort der Probe 14 in Richtung des Detektors 18 größer wird.

Die Figuren 5 und 6 zeigen die Ergebnisse von Modellrechnungen nach dem "ray-tracing"-Verfahren. Dabei wird angenommen, daß eine Probe 14 unter dem Einfluß der Röntgenstrahlung 12 (Primärstrahlung) zwei monoenergetische Fluoreszenzlinien gleicher Intensität aussendet, in diesem Beispiel mit einer Energie von 1,49 keV (Al-Ka_{α}) bzw. 1,46 keV. Die 1,46 keV-Linie ist fiktiv. Sie wurde eingeführt, um den Einfluß einer nur um 30 eV versetzen Linie zu verdeutlichen. Für eine Anordnung gemäß Fig. 1 (Vorrichtung gemäß dem Stand der Technik) zeigt Fig. 5 als Ergebnis derartiger Rechnungen die Röntgenintensität am Detektor, die als Funktion des Winkels zwischen Fluoreszenzstrahlung 11 und dem Multilayerspiegel 17 erhalten wird. Jedes Kreissymbol steht für die Röntgenintensität, die in einer bestimmten Meßzeit für einen bestimmten Winkel des Multilayerspiegels 17 gemessen wird. Die Rechnung simuliert den Meßvorgang, bei dem der Multilayerspiegel 17 sukzessive in ausreichend kleinen Schritten verdreht wird und bei dem für jeden Winkel die Zahl der Fluoreszenzstrahlen 110 registriert wird, die den Detektor 18 in einer bestimmten Meßzeit treffen.

Fig. 6 zeigt das Ergebnis der erfindungsgemäß vorgeschlagenen Lösung, wie es mit einer Vorrichtung 10 gemäß Fig. 2 erreicht wird, gerechnet für dieselben Fluoreszenzlinien bei gleicher Primärintensität, Probengröße und Zusammensetzung. Es wurde der gleiche Multilayerspiegel 17, wenn auch in doppelter Ausführung 17, 170, eingesetzt wie in der Vorrichtung gemäß Fig. 1. Im folgenden werden die Leistungen einer im Stand der Technik bekannten Vorrichtung 10 mit denen der erfindungsgemäßen Vorrichtung 10 verglichen. Dazu wurden die oben erwähnten Modellrechnungen nach dem "ray-tracing"-Verfahren unter Berücksichtigung der röntgenoptischen Eigenschaften der Multilayerspiegel 17, 170 durchgeführt. Es wurde jeweils die Meßprozedur simuliert, indem die Zählrate am Detektor 18 schrittweise für verschiedene Winkel der drehbaren Multilayerspiegel 17, 170 errechnet wurde. Die Ergebnisse der einzelnen Rechnungsschritte sind, wie gesagt, in den Figuren 5 und 6 dargestellt.

Für die Rechnungen wurden folgende Daten verwendet:

### für die bekannte Vorrichtung 10 gemäß Fig. 1:

Ausdehnung der Probe 14 = 10 mm
Abstrahlwinkel der Fluoreszenzstrahlung = 45°
Sollerkollimator 16: Divergenz = 1,5 mrad, Durchlaß 50 %
Multilayerspiegel 17: Länge = 70 mm, 100 Doppelschichten
WSi₂/Si, d-spacing = 4 nm, γ = 0,375

### für die erfindungsgemäße Vorrichtung gemäß Fig. 2:

Ausdehnung der Probe 14 = 10 mm
Abstrahlwinkel der Fluoreszenzstrahlung = 1°
Sollerkollimator 16: entfällt
Entfernung 174 Probe 14 - 1. Spiegel = 160 mm
   1. Multilayerspiegel 17: Länge 171 = 40 mm, 100 Doppelschichten 178 WSi₂/Si, d-spacing von 3,5 bis 4,5 nm, γ = 0,375
   2. Multilayerspiegel 170: Länge 173 = 47 mm, 100 Doppelschichten 178 WSi₂/Si, d-spacing von 3,5 bis 4,5 nm, γ = 0,375
Abstand der Spiegel 172 = 3 mm

Vergleicht man die Figuren 5 und 6 miteinander, so ergibt sich eine klare Überlegenheit der erfindungsgemäßen Vorrichtung 10 gegenüber der im Stand der Technik bekannten Vorrichtung 10 augenfällig, daß sich nämlich die Auflösung gemäß der erfindungsgemäß vorgeschlagenen Lösung von 31 eV auf 27 eV gesteigert hat, wobei auch die Intensität um das 10-fache erhöht ist. Demnach ist besonders die Effektivität der erfindungsgemäßen Lösung gegenüber der durch die im Stand der Technik bekannte Vorrichtung gemäß Fig. 1 erreichbaren erheblich verbessert. Die verbesserte Auflösung der erfindungsgemäßen Vorrichtung 10 ist sogar noch effektiver als es die üblicherweise angegebenen Halbwertsbreiten (fwhm) (S. 27 gegenüber 31 eV) ausdrücken, weil besonders die sog. "tailings", die den Untergrund begünstigen, von der erfindungsgemäßen Lösung wirksam unterdrückt werden.

Mit Hilfe der erfindungsgemäßen Lösung kann die Leistung der in großer Zahl sich im Einsatz befindenden wellenlängen-dispersiven Röntgenfluoreszenzspektrometer, für die im Bereich des Nachweises leichter Elemente Multilayerspiegel 17, 170 als dispergierende Elemente eingesetzt werden, mit vergleichsweise geringen Kosten erheblich gesteigert werden.

Es sei noch darauf hingewiesen, daß die in Fig. 1 dargestellte, im Stand der Technik bekannte Vorrichtung 10 für die mathematische und physikalische Betrachtung der erfindungsgemäßen Vorrichtung 10 gemäß Fig. 2 als Referenzanordnung benutzt wurde. Bei rechnerischen Vergleichen mit der erfindungsgemäßen Vorrichtung 10 wurden Parameter wie Probenausdehnung, Material und Zahl der Schichten 178 der Multilayerspiegel 17, 170 als relevante geometrische Größen nicht verändert, um einen quantitativen Vergleich zwischen der im Stand der Technik bekannten Vorrichtung 10 und der erfindungsgemäßen Vorrichtung 10 an einem realistischen und weitgehend typischen Einzelfall zu demonstrieren. Besonderen Einfluß auf einen derartigen Vergleich hat allerdings die Ausdehnung der Probe 14. Eine größere Probenfläche verschiebt die Kennziffernintensität und Auflösung geringfügig zuungunsten der erfindungsgemäßen Vorrichtung 10, wohingegen eine mehr punktförmige Probe 14 als Quelle der Fluoreszenzstrahlung 11 die Überlegenheit der erfindungsgemäßen Vorrichtung 10 gegenüber der im Stand der Technik bekannten Vorrichtung 10 noch deutlicher hervortreten läßt.

### Bezugszeichenliste

- 10: Vorrichtung
- 11: Fluoreszenzstrahlung
- 110: reflektierte Fluoreszenzstrahlung
- 12: Strahlung (Primärstrahlung)
- 13: Röntgenquelle
- 14: Probe
- 15: Probenoberfläche
- 16: Kollimator
- 17: Multilayerspiegel
- 170: Multilayerspiegel
- 171: Länge des (ersten) Multilayerspiegels
- 172: Abstand der Multilayerspiegel
- 173: Länge des (zweiten) Multilayerspiegels
- 174: Länge des Strahlungswegs der Fluoreszenzstrahlung zum ersten Multilayerspiegel
- 175: Länge des Strahlungswegs der Fluoreszenzstrahlung zum zweien Multilayerspiegel
- 176: Dicke der Vielfachschicht des ersten Multilayerspiegels
- 177: Dicke der Vielfachschicht des zweiten Multilayerspiegels
- 178: Vielfachschicht (Multilayerschicht)
- 18: Detektor

## Patentansprüche

1. Vorrichtung (10) zur wellenlängen-dispersiven Analyse von Fluoreszenzstrahlung (11), die von einer Probenoberfläche (15), insbesondere von einer zu untersuchenden Waferoberfläche, emittiert wird, nachdem auf die Probenoberfläche (15) primäre Strahlung (12) gerichtet worden war, wobei die Fluoreszenzstrahlung (110) auf einen relativ zur Richtung der einfallenden Fluoreszenzstrahlung (110) drehbaren Multilayer-Röntgenspiegel (17, 170) geleitet wird, dessen emittierte Strahlen auf einen Detektor (18) gegeben werden, **dadurch gekennzeichnet, daß** der Reflexionswinkel α, unter dem die Fluoreszenzstrahlung (11) von der Probenoberfläche (15) emittiert wird, << 45° ist, daß der Multilayer-Röntgenspiegel durch ein Paar voneinander beabstandeter Multilayerspiegel (17, 170) gebildet wird, daß der Detektor (18) durch einen ortsabhängigen Detektor gebildet wird und daß die Dicke (176, 177) der Vielfachschichten (178) der Multilayerspiegel (17, 170) mit der Länge (171, 173) der Multilayerspiegel (17, 170) vom Ort der Probe (14) in Richtung des Detektors (18) größer wird.

2. Vorrichtung nach Anspruch 1, **dadurch gekennzeichnet, daß** der Reflexionswinkel α im Bereich von 3° bis 0,05° liegt.

3. Vorrichtung nach Anspruch 2, **dadurch gekennzeichnet, daß** der Reflexionswinkel α im wesentlichen 1° groß ist.

4. Vorrichtung nach einem oder mehreren der Ansprüche 1 bis 3, **dadurch gekennzeichnet, daß** die Multilayerspiegel (17, 170) parallel voneinander beabstandet sind.

5. Vorrichtung nach einem oder mehreren der Ansprüche 1 bis 4, **dadurch gekennzeichnet, daß** die Länge (171) des ersten, näher zur Probe (14) gerichteten Multilayerspiegels (17) kleiner als die Länge (173) des zweiten, näher zum Detektor (18) gerichteten Multilayerspiegels (170) ist.

6. Vorrichtung nach einem oder mehreren der Ansprüche 1 bis 5, **dadurch gekennzeichnet, daß** der Gradient des "d-spacing" des ersten, näher zur Probe (14) gerichteten Multilayerspiegels (17) größer als der Gradient des "d-spacing" des zweiten, näher zum Detektor (18) gerichteten Multilayerspiegels (170) ist.

7. Vorrichtung nach einem oder mehreren der Ansprüche 1 bis 6, **dadurch gekennzeichnet, daß** die Länge (171, 173) der Multilayerspiegel (17, 170) proportional zur Länge (174, 177) ist, die die Fluoreszenzstrahlung (11) von der Probenoberfläche (15) zur jeweiligen Mitte der Multilayerspiegel (17, 170) zurücklegt.

## Claims

1. Apparatus (10) for the wavelength-dispersive analysis of fluorescence radiation (11) emitted by a sample surface (15), in particular from a wafer surface that is to be examined, after directing primary radiation (12) onto the sample surface (15), whereby the fluorescence radiation (110) is guided onto a multi-layer X-ray mirror (17, 170) that is rotatable relative to the direction of the incident fluorescence radiation (110) and whose emitted rays are allowed to fall onto a detector (18), **characterized in that** the reflection angle α at which the fluorescence radiation (11) is emitted from the sample surface (15) is << 45°, **in that** the multi-layer X-ray mirror consists of a pair of multi-layer mirrors (17, 170) spaced a distance apart, **in that** the detector (18) consists of a locus-dependent detector and **in that** the thickness (176, 177) of the multiple layers (178) of the multi-layer mirrors (17, 170) becomes greater as the length (171, 173) of the multi-layer mirrors (17, 170) increases from the sample position (14) towards the detector (18).

2. Apparatus according to Claim 1, **characterized in that** the reflection angle α lies in the range from 3° to 0.05°.

3. Apparatus according to Claim 2, **characterized in that** the magnitude of the reflection angle α is essentially 1 °.

4. Apparatus according to one or more of the Claims 1 to 3, **characterized in that** the multi-layer mirrors (17, 170) are spaced a distance apart and parallel to one another.

5. Apparatus according to one or more of the Claims 1 to 4, **characterized in that** the length (171) of the first multi-layer mirror (17) which is aligned closer to the sample (14) is smaller than the length (173) of the second multi-layer mirror (170) which is aligned closer to the detector (18).

6. Apparatus according to one or more of the Claims 1 to 5, **characterized in that** the gradient of the "d-spacing" of the first multi-layer mirror (17) which is aligned closer to the sample (14) is larger than the gradient of the "d-spacing" of the second multi-layer mirror (170) which is aligned closer to the detector (18).

7. Apparatus according to one or more of the Claims 1 to 6, **characterized in that** the length (171, 173) of the multi-layer mirrors (17, 170) is proportional to the length (distance) (174, 177) traversed by the fluorescence radiation (11) from the sample surface (15) to the respective centre of the multi-layer mirrors (17, 170).

## Revendications

1. Dispositif (10) pour l'analyse dispersive de la longueur d'onde du rayonnement fluorescent (11), qui est émis par une surface d'échantillon (15), plus particulièrement par une surface de plaquette de silicium à examiner, après qu'un rayonnement primaire (12) a été dirigé sur la surface d'échantillon (15), le rayonnement fluorescent (110) étant dirigé sur un miroir à rayons X multicouche (17, 170) pivotant de façon relative par rapport à la direction du rayonnement fluorescent (110) incident, miroir dont les rayons émis sont appliqués à un détecteur (18), **caractérisé en ce que** l'angle de réflexion α, sous lequel le rayonnement fluorescent (11) est émis par la surface d'échantillon (15), est inférieur à 45°, **en ce que** le miroir à rayons X multicouche est formé par une paire de miroirs multicouches (17, 170) espacés l'un de l'autre, **en ce que** le détecteur (18) est formé par un détecteur dépendant du lieu et **en ce que** l'épaisseur (176, 177) des couches multiples (178) des miroirs multicouches (17, 170) augmente avec la longueur (171, 173) des miroirs multicouches (17, 170) de l'endroit de l'échantillon (14) en direction du détecteur (18).

2. Dispositif selon la revendication 1, **caractérisé en ce que** l'angle de réflexion α se situe dans une plage de 3° à 0,05°.

3. Dispositif selon la revendication 2, **caractérisé en ce que** l'angle de réflexion α vaut sensiblement 1°.

4. Dispositif selon l'une quelconque ou plusieurs des revendications 1 à 3, **caractérisé en ce que** les miroirs multicouches (17, 170) sont espacés parallèlement les uns des autres.

5. Dispositif selon l'une quelconque ou plusieurs des revendications 1 à 4, **caractérisé en ce que** la longueur (171) du premier miroir multicouche (17) proche de l'échantillon (14) est inférieure à la longueur (173) du second miroir multicouche (170) proche du détecteur (18).

6. Dispositif selon l'une quelconque ou plusieurs des revendications 1 à 5, **caractérisé en ce que** le gradient de « l'espacement d » du premier miroir multicouche (17) proche de l'échantillon (14) est supérieur au gradient de « l'espacement d » du second miroir multicouche (170) proche du détecteur (18).

7. Dispositif selon l'une quelconque ou plusieurs des revendications 1 à 6, **caractérisé en ce que** la longueur (171, 173) des miroirs multicouches (17, 170) est proportionnelle à la longueur (174, 177) qui replace le rayonnement fluorescent (11) de la surface d'échantillon (15) vers le milieu respectif des miroirs multicouches (17, 170).
